# EUROPÄISCHE PATENTSCHRIFT

(11) **EP 0 984 076 B1**
(45) Veröffentlichungstag und Bekanntmachung des Hinweises auf die Patenterteilung: **10.04.2002**
(21) Anmeldenummer: 99110375.5
(22) Anmeldetag: 28.05.1999
(51) Int. Cl.: C23C 14/56

(54) **Vorrichtung zur Beschichtung von Substraten in einer Vakuumkammer**
Apparatus for coating substrates in a vacuum chamber
Appareillage pour former un revêtement sur des substrats dans une chambre à vide

(30) Priorität: 04.08.1998 DE 19835154
(43) Veröffentlichungstag der Anmeldung: 08.03.2000
(73) Patentinhaber: Unaxis Deutschland Holding GmbH, 63450 Hanau (DE)
(72) Erfinder: Bräuer, Günter, Dr., 63579 Freigericht (DE); Kloberdanz, Hermann ,Dr., 63589 Linsengericht (DE); Lotz, Hans Georg, Dr., 65384 Gründau (DE); Schneider, Jochen, 64409 Messel (DE); Zöller, Alfons, 63628 Bad Soden-Salmünster (DE); Hagedorn, Harro, Dr., 60435 Frankfurt (DE); König, Michael, 60529 Frankfurt (DE); Meinel, Jürgen, 63225 Langen (DE); Teschner, Götz, 01307 Dresden (DE)

(56) Entgegenhaltungen:
- EP-A- 0 589 416
- US-A- 5 310 410
- US-A- 5 759 268

## Beschreibung

Die Erfindung betrifft eine Vorrichtung zur Beschichtung von Substraten im Vakuum mit einem rotierbaren Substratträger mit mindestens einer Beschichtungsstation und mit einer Belade- und Entladestation.

Bekannt ist eine Kathodenzerstäubungsanlage zur Beschichtung von Substraten in einer Vakuumkammer (DE 39 12 295), in der ein rotierender Substratträger untergebracht ist, mit mindestens einer Kathodenstation, einer Beladestation und Entladestation, wobei der Substratträger aus mindestens einer Transportkelle besteht und die Transportkelle einen Substrataufnahmekörper (Aufnahmekörper) umfaßt, der vorzugsweise in Richtung der Achse der Kathodenstation, beziehungsweise der Beladestation, beziehungsweise der Entladestation bewegbar ist, wobei die Transportkelle aus einem vorzugsweise kreisscheibenförmig ausgebildeten Substrataufnahmekörper und einem Arm gebildet ist, der so ausgebildet und angeordnet ist, daß der Aufnahmekörper in Hinsicht auf die mit ihm zusammenwirkenden Teilen der Anlage, wie Teilen der zerstäubungskathode, Teilen der Beladestation, Teilen der Entladestation während seiner Bewegung stets parallel zu diesen Teilen ausgerichtet ist.

Für eine oder mehrere Transportkellen ist eine in Bezug auf die Kathodenzerstäubungsanlage zentral angeordnete Antriebsvorrichtung vorgesehen, die die Transportkelle um einen bestimmten Winkel schrittweise in der Vakuumkammer der Kathodenzerstäubungsanlage weitertransportiert, wobei die Vakuumkammer der Kathodenzerstäubungsanlage senkrecht angeordnet ist und die Transportkelle, beziehungsweise die Transportkellen um eine waagerecht angeordnete Achse rotieren.

Diese bekannte Kathodenzerstäubungsanlage ist insbesondere geeignet für die Beschichtung von kreisscheibenförmigen flachen Datenträgern, die in einer Vakuumkammer mit mehreren dünnen Schichten versehen werden, wobei sämtliche Schichten mittels Sputterverfahren aufgebracht werden.

Bekannt ist weiterhin eine Vorrichtung zum Einund Ausschleusen eines im wesentlichen flachen Werkstücks in eine evakuierte Beschichtungskammer und zum Zuführen und Rückführen des Werkstücks in und aus dem Bereich einer Beschichtungsquelle zum Zwecke der Behandlung der Werkstückoberfläche (DOS 37 16 498), wobei eine im Bereich der Beschichtungskammer angeordnete Beschichtungsvorrichtung mit einem oder mehreren deckelförmigen Werkstückträgern vorgesehen ist, mit Hilfe derer die Werkstücke in eine einer Öffnung der Beschichtungskammer benachbarte Position bringbar sind, von der aus die Öffnung einerseits vom Werkstückträger und andererseits von einem Hubteller verschließbar ist, der auf einem innerhalb der Beschichtungskammer rotierbar gelagerten Drehteller gehalten und geführt ist, wobei der Werkstückträger von einem sich an der Beschichtungsvorrichtung abstützenden Hubzylinder an die Öffnung im Deckel der Beschichtungskammer und der Hubteller von einer an der Bodenplatte befestigten Hubvorrichtung anpreßbar ist.

Auch diese bekannte Vorrichtung ist nur für eine Beschichtung mit Hilfe von Sputterkathoden vorgesehen.

Weiterhin ist ein Reinraum mit einer Fördereinrichtung, die Transportbehälter von einer Bearbeitungsstation zur nächsten transportiert, bekannt (DE 36 03 538) mit folgenden Merkmalen:
- der Reinraum ist voll kapselbar,
- mindestens eine Zufuhr- und Entnahmerichtung überführt die Carrier über eine Schleuse in den Arbeitsbereich der Fördereinrichtung und entnimmt sie über eine Schleuse,
- die Fördereinrichtung weist einen um eine Achse drehbaren Carrier-Trägerarm auf und
- die Bearbeitungsstationen sind im Schwenkbereich des Trägerarms angeordnet, wobei die Zufuhr- und Entnahmeeinrichtung mindestens eine Drehscheibe mit Abschirmung zwischen den Transportbehältern ausweist.

Bekannt ist schließlich eine optische Linse aus einem klarsichtigen Kunststoff und einer ersten Schicht aus SiO unmittelbar auf dem Substrat (DE 44 30 363), wobei die zweite Schicht aus Borosilicatglas mit einem Brechwert von 1,47 (Lambda 55 nm) gebildet ist und eine Dicke von bis zu 3 µ, vorzugsweise 2550 nm aufweist und die Schichten drei bis sieben zum Zwecke einer Antireflexwirkung aus TiO₃, SiO₂, Al₂O₃ gebildet sind. Die Vorrichtung für die Erzeugung der dünnen Schichten auf der Kunststofflinie ist dazu ausgestattet mit einer Piasmaquelle gegenüber dem Kunststoffsubstrat mindestens einen Verdampfer neben der Plasmaquelle und mindestens einen Ringmagnet oberhalb des Substrats.

Der vorliegenden Erfindung liegt die Aufgabe zugrunde, insbesondere sphärisch geformte Substrate, beispielsweise Brillengläser in einem kontinuierlichen Prozeß mit Schichten zu versehen, die bei einer besonders hohen Schichtdickengleichmäßigkeit mittels verschiedenartiger Beschichtungsquellen aufgebracht werden.

Diese Aufgabe wird erfindungsgemäß dadurch gelöst, daß zwei benachbarte Vakuumkammern vorgesehen sind, wobei in jeder der beiden Kammern ein rotierbarer Substratträger vorgesehen ist, wobei die Rotationsachse beider Substratträger parallel zueinander ausgerichtet sind und die Transportebenen der Substratträger zueinander fluchten, wobei im Trennungsbereich der beiden Kammern Schleusen mit einer mit den beiden Substratträgern korrespondierenden Substratübergabevorrichtung vorgesehen ist und wobei eine der Kammern die Belade- und Entladestation aufweist.

Weitere Einzelheiten und Merkmale der Erfindung sind in den Patentansprüchen näher beschrieben und gekennzeichnet.

Die Erfindung läßt die verschiedensten Ausführungsmöglichkeiten zu; eine davon ist in anhängenden Zeichnungen schematisch dargestellt, die eine Vorrichtung der in Frage stehenden Art in mehreren Prozeßphasen in der Draufsicht zeigen.

Die Vorrichtung besteht im wesentlichen aus zwei voneinander getrennten, jedoch unmittelbar benachbarten Vaküumkammern 3, 4, einer im Trennungsbereich beider Vakuumkammern 3, 4 angeordneten einen rotierbaren Transportteller 20 aufweisenden Substratübergabevorrichtung 5, zwei in der ersten Vakuumkammer 3 vorgesehenen PECVD (Plasma Enhanced Chemical Vapour Deposition) - Quellen 6, 7, einer Einschleusstation 8 und einer Ausschleusstation 9, insgesamt fünf in der zweiten Vakuumkammer 4 angeordneten Sputter-Quellen (Zerstäubungsquellen) 10 bis 14 und in beiden Vakuumkammern 3, 4 gelagerten und jeweils um vertikale Achsen A bzw. B rotierbare Transportarme 15, 16 mit jeweils an deren freien Enden angebrachten Greifern 17, 18 zum Halten der Substrate 19, 19'.

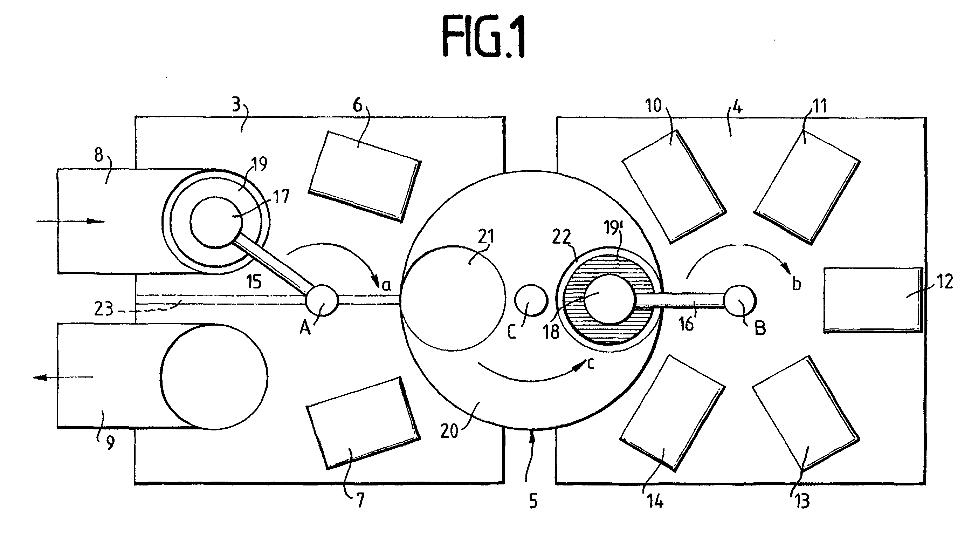

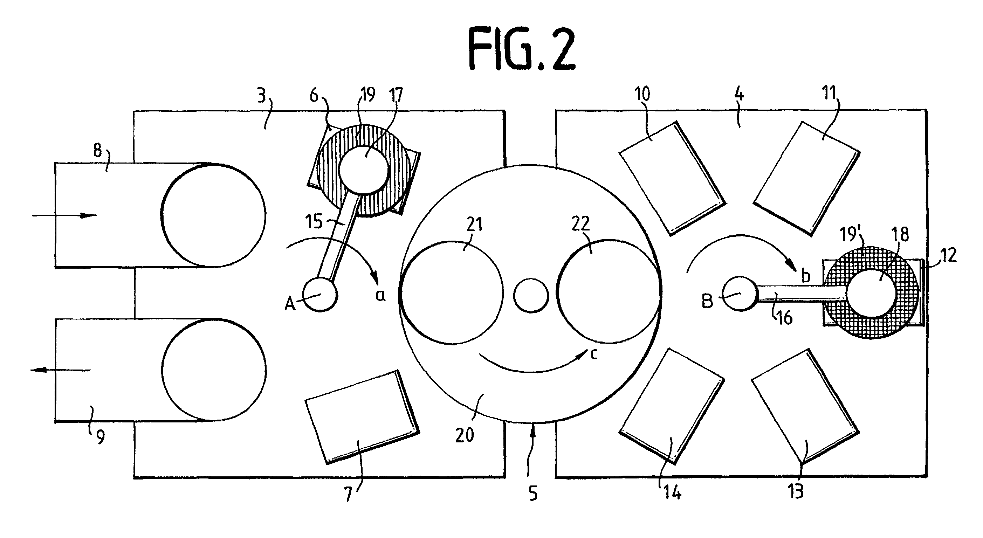

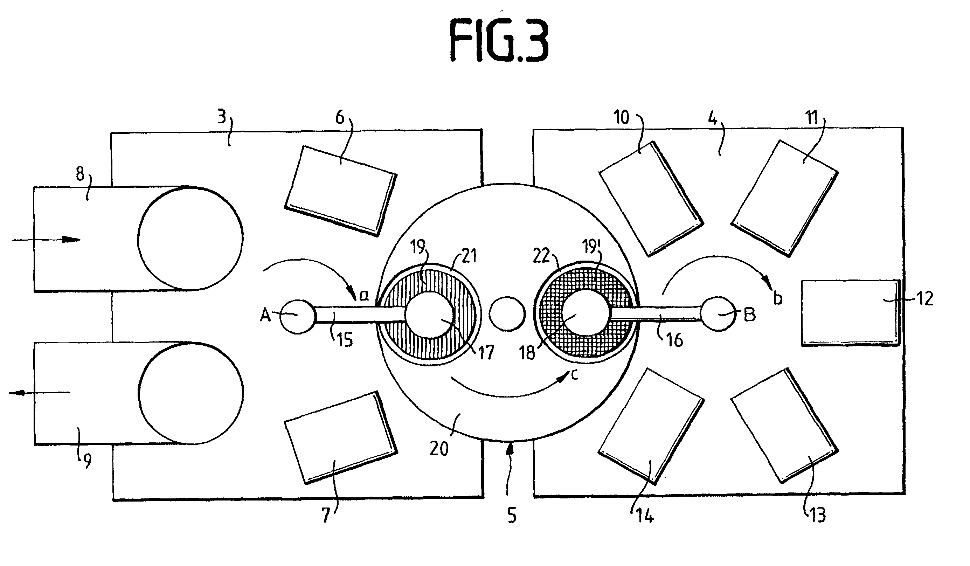

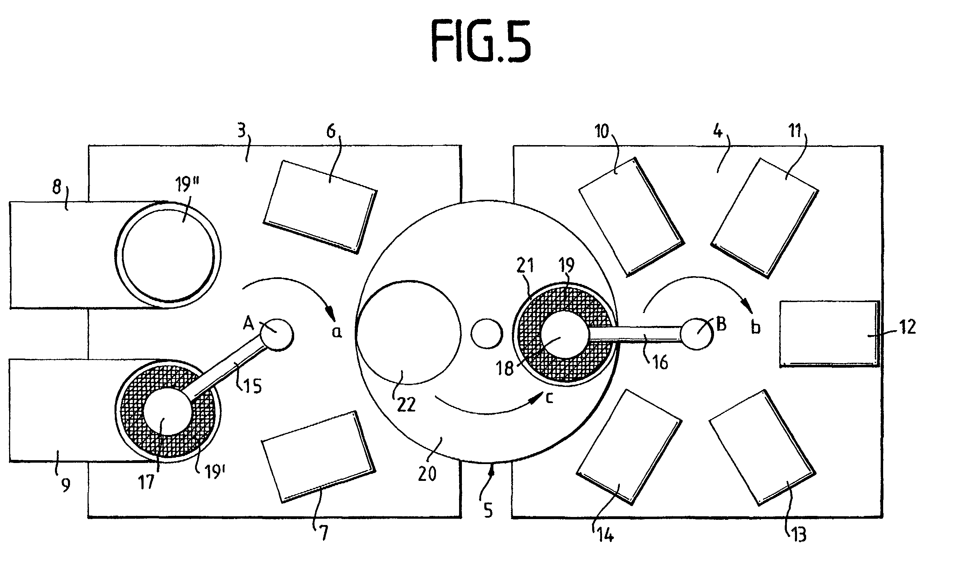

In der in Fig. 1 dargestellten Prozeßphase ist ein Substrat 19 in die Vakuumkammer 3 eingeschleust und vom Transportarm 15 bzw. dessen Greifer 17 übernommen worden, gleichzeitig befindet sich ein zweites bereits mit einer ersten Schicht versehenes Substrat 19' im Bereich der Übergabevorrichtung 5, wo es vom Transportarm 16 bzw. dessen Greifer 18 übernommen worden ist. Zum Zwecke der weiteren Beschichtung wird nun das noch unbehandelte Substrat 19 schrittweise vom Transportarm 15 in den Bereich der PECVD-Quelle 6 transportiert, wo es eine vorherbestimmte Zeit lang verbleibt, während gleichzeitig im selben Zeitabschnitt das Substrat 19' aus seiner Position auf dem Transportteller 20 der Übergabestation 5 in einer gleichmäßigen Transportbewegung vom Transportarm 16 in Pfeilrichtung b an den Sputterquellen 10, 11 vorbei bis in den Bereich der Quelle 12 bewegt (siehe Fig. 2) wird. In den nächsten Phasen des Beschichtungsprozesses bewegt sich das Substrat 19 schrittweise in der in Fig. 3 gezeigten Position auf dem Transportteller 20, wo es eine bestimmte Zeit lang verharrt bis sich das Substrat 19' von der Quelle 12 her bis zum Transportteller 20 bewegt hat. In der nächsten Phase des Beschichtungsprozesses wird der Transportteller in Pfeilrichtung c um 180° gedreht, so daß die Substrate 19, 19' ihre Position auf dem Drehteller 20 vertauschen und das Substrat 19' noch in einem Transportschritt über der Quelle 7 positioniert ist, während das Substrat 19 gleichmäßig in Pfeilrichtung b bis über die Quelle 12 verschwenkt wird. In der nächsten, in Fig. 5 dargestellten Phase des Beschichtungsprozesses erreicht das fertig beschichtete Substrat 19' die Ausschleusstation 9, während das mit sechs Schichten versehene Substrat 19 eine Position auf dem Drehteller 20 erreicht. Es ist klar, daß der vorstehend geschilderte Verfahrensablauf so abgestimmt ist, daß gleichzeitig mit dem Ausschleusen eines vollständig beschichteten mit sieben Schichten versehenen Substrats 19, 19' ... ein noch unbeschichtetes weiteres Substrat 19", 19'", ... über die Station 8 in die Vakuumkammer 8 eingeschleust wird, so daß ein kontinuierlich arbeitender Verfahrensablauf erreicht wird.

Die in die Vakuumkammer 3 eingebrachten Prozeßgase können beispielsweise HMDSO (Hexamethyldisiloxan) und Sauerstoff/Stickstoff sein, wobei die mit der Quelle 6 erzeugte Schicht eine Kratzschutzschicht und die mit der Quelle 7 erzeugte Schicht eine wasserabstoßende Schicht sein kann, wozu die Queller. 6, 7 jeweils an eine R. F.-Stromversorgung angeschlossen sind.

Bei den in der Vakuumkammer 4 angeordneten Quellen 10 bis 14 handelt es sich um Kathoden mit metallischen Targets zum Aufstäuben von reaktiven Schichten (z. B. Titandioxid, Siliziumdioxid), wozu die Prozeßgase beispielsweise Sauerstoff und Argon sein können.

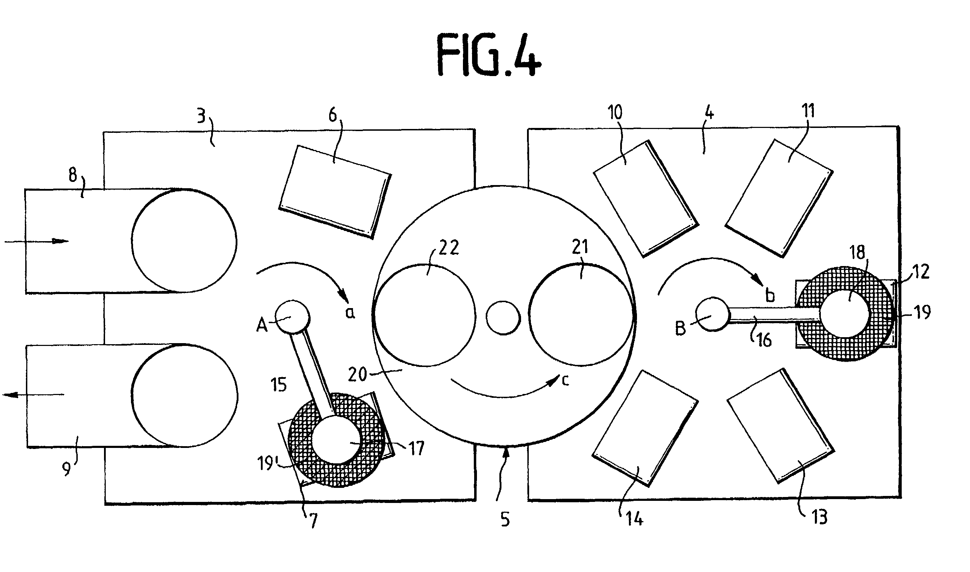

Wie aus den Figuren 1 bis 5 ersichtlich, wirken die die beiden Transportarme 15, 16 und den Transportteller 20 antreibenden Motore so zusammen, daß die Substrate 19, 19', ... im Bereich der beiden Quellen 6, 7 jeweils länger verweilen als jeweils im Bereich einer der Quellen 10 bis 14, wozu der Transportarm 15 sich sprungartig oder schrittweise bewegt und somit eine statische Beschichtung ermöglicht, während der Transportarm 16 kontinuierlich umläuft und somit dynamische Beschichtungen ermöglicht.

Es ist klar, daß anstelle von insgesamt fünf verschiedenen Beschichtungsquellen 10 bis 14 in der Vakuumkammer 4 beispielsweise auch nur zwei Beschichtungsquellen vorgesehen sein können, (z. B. zur Erzeugung einer hochbrechenden und einer niederbrechenden Schicht), wozu dann die Synchronisation der umlaufenden Teile, d. h. der Transportarme 15, 16 bzw. des Transporttellers 20 entsprechend abzustimmen ist.

Im Falle, daß der Betrieb der Quellen 6, 7 der einen Vakuumkammer 3 unterschiedliche Drücke und/oder Prozeßgase erfordert, ist in diese Kammer 3 ein Schott 23 in Gestalt eines Blechzuschnitts mit einer Spaltschleuse für den Durchtritt des Transportarms 15 mit Substratgreifer 17 einsetzbar. Das Schott 23 ist in Fig. 1 mit strichlierten Linien angedeutet.

### Bezugszeichenliste

- 2 3: Vakuumkammer
- 4: Vakuumkammer
- 5: Substratübergabevorrichtung
- 6: PECVD-Quelle, Elektrode
- 7: PECVD-Quelle, Elektrode
- 8: Einschleusstation
- 9: Ausschleusstation
- 10: Sputter-Quelle, Kathode
- 11: Sputter-Quelle, Kathode
- 12: Sputter-Quelle, Kathode
- 13: Sputter-Quelle, Kathode
- 14: Sputter-Quelle, Kathode
- 15: Transportarm
- 16: Transportarm
- 17: Substrat-Greifer
- 18: Substrat-Greifer
- 19, 19', ...: Substrat
- 20: Transportteller
- 21: Substrathalter
- 22: Substrathalter
- 23: Schott

## Patentansprüche

1. Vorrichtung zur Beschichtung von Substraten im Vakuum mit einem rotierbaren Substratträger (15, 16, 20) mit mindestens einer Beschichtungsstation (6, 7 bzw. 10 bis 14) und mit einer Belade- und Entladestation (8 bzw. 9), **dadurch gekennzeichnet, daß** zwei Vakuumkammern (3, 4) unmittelbar benachbart vorgesehen sind, wobei in jeder der beiden Kammern (3, 4) ein rotierbarer Substratträger oder Transportarm (15 bzw. 16) gelagert ist, wobei die Rotationsächsen beider Transportarme (15, 16) parallel zueinander verlaufen und die Transportebenen der Transportarme (15, 16) miteinander fluchten, wobei im Trennungsbereich der beiden Kammern (3, 4) eine Schleuse mit einer mit den beiden Transportarmen (15, 16) korrespondierenden Übergabevorrichtung (5) vorgesehen ist und die eine Kammer (3) die Belade- und die Entladestation (8 bzw. 9) aufweist.

2. Vorrichtung nach Anspruch 1, **dadurch gekennzeichnet, daß** die Übergabevorrichtung (5) einen motorisch angetriebenen Drehteller (20) mit mindestens zwei Substratablagen oder Substrathaltern (21, 22) aufweist, die in einer Ebene mit den Greifern (17, 18) der Transportarmen (15, 16) rotierbar sind, wobei der Transportteller (20) jeweils etwa hälftig in beide Vakuumkammern (3, 4) hineinragt und gegenüber den benachbarten Kammerwänden mittels Spaltschleusen abgedichtet ist.

3. Vorrichtung nach den Ansprüchen 1 und 2, **dadurch gekennzeichnet, daß** die eine oder beide Kammern (3, 4) zum Zwecke der Gastrennung Schotten (23) aufweisen, die den Prozeßraum (3 und 4) teilen, die jeweils mit einer Spaltschleuse in der Rotationsebene der Transportarme (15, 16) für deren Durchtritt versehen sind.

4. Vorrichtung nach den Ansprüchen 1 und/oder 2, **dadurch gekennzeichnet, daß** die Transportarme (15, 16) und der Transportteller (20) von einer Motor-Getribeeinheit angetrieben sind, wobei die Welle (A) für den einen Transportarm und die Welle (C) des Transporttellers (20) schrittweise und die Welle (B) des anderen Transportarms (16) kontinuierlich rotieren.

## Claims

1. Device for coating substrates in a vacuum, with a rotatable substrate carrier (15, 16, 20) with at least one coating station (6, 7; 10 to 14) and with a loading and unloading station (8, 9), **characterized in that** two vacuum chambers (3, 4) are provided immediately adjacent to one another, a rotatable substrate carrier or conveying arm (15, 16) being supported in each of the two chambers (3, 4), the axes of rotation of the two conveying arms (15, 16) running parallel to one another and the conveying planes of the conveying arms (15, 16) being aligned with one another, a lock with a transfer device (5) corresponding with the two conveying arms (15, 16) being provided in the area of separation of the two chambers (3, 4) and one chamber (3) having the loading and unloading station (8, 9).

2. Device according to claim 1, **characterized in that** the transfer device (5) has a motor-driven rotary table (20) with at least two substrate depositories or substrate holders (21, 22), which are rotatable in a plane with the grippers (17, 18) of the conveying arms (15, 16), roughly one half of the conveying table (20) protruding into each of the two vacuum chambers (3, 4) and being sealed against the adjacent chamber walls by means of slit locks.

3. Device according to claims 1 and 2, **characterized in that** one or both chambers (3, 4) have bulkheads (23) for the purpose of gas separation, which bulkheads divide the process area (3 and 4) and which are each provided with a slit lock in the plane of rotation of the conveying arms (15, 16) for the passage of the latter.

4. Device according to claims 1 and/or 2, **characterized in that** the conveying arms (15, 16) and the conveying table (20) are driven by a motor-gearbox unit, the shaft (A) of one conveying arm and the shaft (C) of the conveying table (20) rotating stepwise and the shaft (B) of the other conveying arm (16) rotating continuously.

## Revendications

1. Dispositif pour revêtir des substrats sous vide, comportant un porte-substrat rotatif (15, 16, 20), au moins une station de revêtement (6, 7 ou 10 à 14) et une station de chargement et de déchargement (8 ou 9), **caractérisé en ce que** deux chambres à vide (3, 4) sont prévues immédiatement au voisinage l'une de l'autre, un porte-substrat rotatif ou un bras de transport (15 ou 16) est monté dans chacune des deux chambres (3, 4), les axes de rotation des deux bras de transport (15, 16) s'étendent parallèlement l'un à l'autre et les plans de transport des bras de transport (15, 16) sont en alignement l'un avec l'autre, un sas est prévu dans la zone de séparation des deux chambres (3, 4) et comprend un dispositif de transfert (5) correspondant aux deux bras de transport (15, 16), et l'une des chambres (3) comprend la station de chargement et de déchargement (8 ou 9).

2. Dispositif selon la revendication 1, **caractérisé en ce que** le dispositif de transfert (5) comprend un plateau tournant (20) entraîné par moteur et comportant au moins deux appuis de substrat ou porte-substrat (21, 22) qui peuvent tourner dans un plan avec les griffes (17, 18) des bras de transport (15, 16), et **en ce que** le plateau de transport (20) pénètre respectivement approximativement à moitié dans les deux chambres à vide (3, 4) et est étanché par rapport aux parois de chambre voisines au moyen de sas à fente.

3. Dispositif selon les revendications 1 et 2, **caractérisé en ce que** l'une ou les deux chambres (3, 4) présentent des écrans (23) à titre de séparation de gaz qui séparent la chambre de réaction (3 et 4) et qui sont pourvus chacun d'un sas à fente dans le plan de rotation des bras de transport (15, 16) pour leur passage.

4. Dispositif selon les revendications 1 et/ou 2, **caractérisé en ce que** les bras de transport (15, 16) et le plateau de transport (20) sont entraînés par une unité à moto-réducteur, et l'arbre (A) pour l'un des bras de transport et l'arbre (C) du plateau de transport (20) tournent pas à pas, et l'arbre (B) de l'autre bras de transport (16) tourne en continu.
